# EUROPEAN PATENT APPLICATION

(11) **EP 3 747 832 A1**
(43) Date of publication of application: **09.12.2020**
(21) Application number: 19717954.2
(22) Date of filing: 01.02.2019
(51) Int. Cl.: C01G 17/00, C22B 41/00

(54) **FEW-LAYER ALPHA-GERMANIUM CRYSTAL, THEIR PREPARATION PROCESSES AND USES THEROF**

(30) Priority: 02.02.2018 ES 201830094
(71) Applicant: Nanoinnova Technologies S.L., 45200 Illescas (ES); Universidad Autónoma de Madrid, 28049 Madrid (ES)
(72) Inventor: ZAMORA ABANADES, Félix Juan, 28049 Madrid (ES); GIBAJA PALACIOS, Carlos, 28049 Madrid (ES); RODRÍGUEZ SAN MIGUEL, David, 28049 Madrid (ES); GÓMEZ HERRERO, Julio, 28049 Madrid (ES); ARES GARCÍA, Pablo, 28049 Madrid (ES); PALACIOS BURGOS, Juan José, 28049 Madrid (ES); FERRITO CRESPO, Rafael, 45200 Illescas, Toledo (ES); GOÑI URTIAGA, Asier, 45200 Illescas, Toledo (ES)
(74) Representative: ABG Intellectual Property Law, S.L.
(86) International application number: PCT/ES2019/070052
(87) International publication number: WO 2019/149985

(57) **Abstract**

The present invention provides α-germanium crystals of lamellar morphology, wherein said crystal comprises one or more nanosheets of germanium stacked on top of one another, as well as two methods of obtaining said crystals. The invention also provides the powder comprising the α-germanium crystals of the invention, dispersions comprising the α-germanium crystal of the invention or the powder of the invention, as well as the ink comprising said dispersions.

## Description

### FIELD OF THE INVENTION

The present invention is comprised in the field of germanium crystals. The present invention particularly relates to α-germanium crystals of lamellar morphology.

### BACKGROUND OF THE INVENTION

Current use of semiconductor materials comprising elements from group 14 of the periodic table, such as silicon or germanium, in electronic devices has caused the interest surrounding materials derived from these elements to grow exponentially. These materials have not only an application in the field of transistors, but both silicon and germanium make up the primary component in the photovoltaic industry [A. Polman et al., Science, 2016, 15, vol. 352, 6283, p. 4424] and photodetector industry [Nam JH, Opt. Express. 2015 Jun 15;23(12): 1581623, US 4725870 A]. However, despite their excellent performance in the aforementioned fields, given that they are semiconductors, and therefore due to the band-gap they possess, their efficiency in optoelectronic applications may occasionally be limited.

There are various morphological types of silicon and germanium for sale, although these are primarily sold in bulk and in nanocrystalline form. However, the potential of these materials for a wide range of applications has sparked growing interest in the search for new nanostructured morphologies, such as nanowires, nanoparticles, or porous forms of materials [Vaughn II, Schaak, Chem. Soc. Reviews, 2013.42(7), 2861-2879; McVey, 2017, ChemPlusChem., 82(1), 60-73; Zeng W., 2016, J. of Nanotech.]. In fact, these new nanostructures are expected to be highly applicable and efficient in technical fields such as energy storage, sensors, microelectronics, and photonics [Usman, M. et al., Advanced Materials, 2017, 29(6); Liu, H., et al., Chem. Soc. Reviews, 44(9), 2732-2743; Lemme, M. C., et al., Mrs Bulletin, 2014, 39(8), 711].

However, the heaviest elements of group 14 of the periodic table, such as Si, Ge, or Sn, do not form strong π bonds due to their larger atomic radius. This results in a larger bond distance between atoms and hinders overlap by means of the π bond of the nearest p orbitals. Therefore, the two-dimensional structures of Si or Ge with sp² hybridization similar to graphene are not promoted, and structures similar to diamond are typically generated by means of bonds to four neighboring atoms with sp³ hybridization, which are ultimately more stable.

Pathways for preparing nanoparticles and nanowires from these materials are known [Vörös, M., et al., J. of Mater. Chem. A, 2014, 2(25), 9820-9827; Wang, L. et al., Dalton Transactions, 2016, 45(7), 2814-2817], however, obtaining new nanostructures that are not those already mentioned may be of great interest if they produce nanomaterials with new physical properties. Furthermore, the development of alternative production methods for producing new nanostructured forms of Si and Ge are of great interest due to their subsequent potential application in specific technologies. Those methods of obtaining these new nanostructures which allow the large-scale production of these nanomaterials should particularly be mentioned, since most known synthesis processes are carried out on a laboratory scale. Therefore, synthesis pathways are required to enable marketing these products and implementing them in the industry at an affordable cost.

Therefore, there is a need in the state of the art for new germanium nanostructures, as well as for the development of new method of obtaining same that can be produced on an industrial scale.

### OBJECT OF THE INVENTION

The present invention provides a new germanium crystal with a diamond-type structure (a-germanium) exhibiting a lamellar morphology. The α-germanium crystals provided by the present invention have not been described until now. Particularly, the crystal of the invention, unlike germanium and germanene oxide, has a cubic crystal structure (sp³). In this sense, due to their structure, the α-germanium crystals of the present invention have a larger surface area than known germanium nanostructures do, requiring a smaller amount of material for their application. Furthermore, unlike germanene crystals, the developed α-germanium crystal presents high stability due to its diamond-type crystal structure. Likewise, germanene crystals are usually produced by epitaxial growth on a support, while the α-germanium crystals provided in the present invention do not require the presence of a support.

Therefore, one aspect of the invention relates to an α-germanium crystal with lamellar morphology, wherein said crystal comprises one or more α-germanium nanosheets stacked on top of one another, and wherein said crystal exhibits a thickness comprised between 0.56 and 100 nm and lateral dimensions comprised between 0.1 µm x 0.1 µm and 10 µm x 10 µm.

Another aspect of the invention relates to a first method of preparing the α-germanium crystal of the invention comprising grinding polycrystalline α-germanium at a rotating speed comprised between 1000 and 3000 rpm in the presence of at least one alcohol, wherein said alcohol is a linear, branched, or cyclic chain alcohol and has a number of carbons comprised between 3 and 5 atoms; or in the presence of a mixture comprising at least one alcohol and water, wherein said alcohol of the mixture is a linear, branched, or cyclic chain alcohol and has a number of carbons comprised between 3 and 5 atoms, and wherein the content of said alcohol in said mixture is comprised between 60% and 99% by volume.

Another aspect of the invention relates to a second method of preparing the α-germanium crystal, which method comprises:
a) preparing a dispersion of polycrystalline α-germanium in:
   - at least one alcohol, wherein said alcohol is a linear, branched, or cyclic chain alcohol and has a number of carbons comprised between 3 and 5 atoms; or
   - in a mixture comprising at least one alcohol and water, wherein said alcohol of the mixture is a linear, branched, or cyclic chain alcohol and has a number of carbons comprised between 3 and 5 atoms, and wherein the content of said alcohol in said mixture is comprised between 60% and 99% by volume,
b) sonicating and centrifuging the dispersion obtained in a), wherein the centrifugation speed is comprised between 500 rpm and 3000 rpm,
c) separating the supernatant to obtain the α-germanium crystal of the invention.

Obtaining a new α-germanium crystal with lamellar morphology from polycrystalline α-germanium available on the market provides a wide range of possibilities regarding its properties and applications. On one hand, the nanometric thickness of the α-germanium sheets can be controlled, and the properties of the material (such as the band-gap) can be adapted to the application thereof. On the other hand, taking into account the scarcity of germanium in the Earth's crust, the simple and direct production of α-germanium nanostructures with a large surface area allows for maximum use thereof, with a smaller amount of material therefore being required for their application.

Another aspect of the invention relates to the powder comprising the α-germanium crystal of the invention. Unlike the germanene nanostructure, which is produced by epitaxial growth on a given support, the α-germanium crystal of the invention is obtained in powder form, and therefore does not require the presence of a support. In this sense, another aspect of the present invention relates to an electronic device comprising the α-germanium crystal of the invention or the powder comprising the α-germanium crystal of the invention.

Furthermore, due to its wetting properties, the α-germanium powder of the invention can be dispersed in organic solvents, water, or a mixture of both. Therefore, another aspect of the invention relates to a dispersion comprising the powder of the invention dispersed in water, organic solvents, or in a mixture of water and organic solvents. Also, another aspect of the invention relates to an ink comprising said dispersion. The good wettability and drying capacity of the crystal of the invention provide for a number of applications, such as, for example, ink printing, spray deposition, or by means of spin-coating. Therefore, an additional aspect of the invention relates to the method of application of the dispersion of the invention or of the ink of the invention comprising the application of the dispersion or of the ink by means of screen-printing, drop-casting, spraying, or spin-coating.

### FIGURES

Figure 1 shows the powder diffractogram of the α-germanium crystal of the invention.
Figure 2 shows: a) TEM image of a nanosheet of the α-germanium crystal of the invention, and b) detail of the nanosheet in a), and electron diffraction pattern of the nanosheet (inserted image).
Figure 3 shows: a) the FTIR spectrum and b) the Raman spectrum of the crystal of the invention.
Figure 4 shows: a) SEM image of the crystals of the invention; b) histogram of areas of the crystals observed in a); and c) DLS characterization of the dispersions generated from the material obtained.
Figure 5 shows: a and c) topographical images obtained by means of AFM of a crystal of the invention; b and d) height profiles of the crystal of the invention of Figures 5 a) and c), respectively.
Figure 6 shows the variation in band-gap with the number of nanosheets of the α-germanium crystal of the invention using the GGA and HSE approximation.

### DETAILED DESCRIPTION OF THE INVENTION

The present invention provides α-germanium crystal with lamellar morphology, wherein said crystal comprises one or more α-germanium nanosheets stacked on top of one another, and wherein said crystal exhibits a thickness comprised between 0.56 nm and 100 nm and lateral dimensions comprised between 0.1 µm x 0.1 µm and 10 µm x 10 µm.

The term "crystal" in the context of the present invention refers to a material exhibiting an atomic structure in which the atoms are ordered with respect to one another. Particularly, in the α-germanium crystal of the invention the atoms are ordered with respect to one another in a diamond-type cubic structure. In fact, the term "α" in the expression "a-germanium crystal" refers to the germanium atoms in the crystal being ordered in a diamond-type cubic structure. The diamond-type cubic structure is based on a face-centered cubic or fcc lattice. Particularly, the primitive cell of the diamond-type structure consists of two fcc lattices, one of them being shifted ¼ with respect to the diagonal of the cube of the first lattice. The main characteristic of the diamond-type structure is that each atom is bound to four other neighboring atoms (tetrahedral bond).

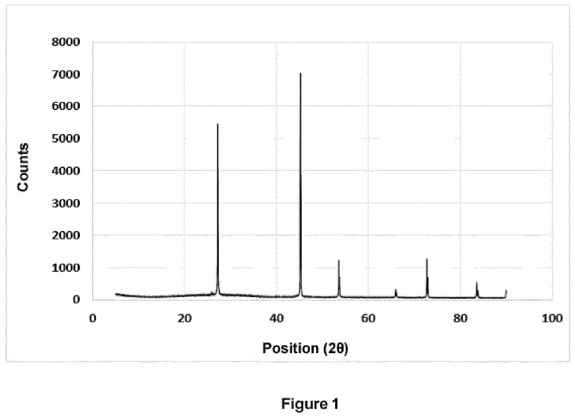

Figure 1 shows the powder diffractogram measured in α-germanium crystal of the invention. The diffractogram confirms that the germanium crystal of the invention has type α structure, wherein the germanium atoms are ordered forming a diamond-type structure.

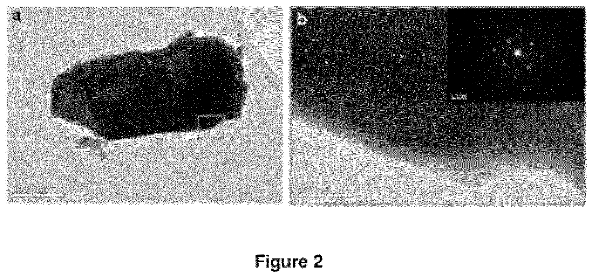

Figure 2 shows the TEM image of a nanosheet of the α-germanium crystal of the invention. Particularly, Figure 2b shows a detail of the nanosheet of the crystal of the invention where the ordering of the germanium atoms can be seen. The electron diffraction pattern of the crystal (inserted image in Figure 2b) confirms the type α cubic structure of the α-germanium crystal of the invention.

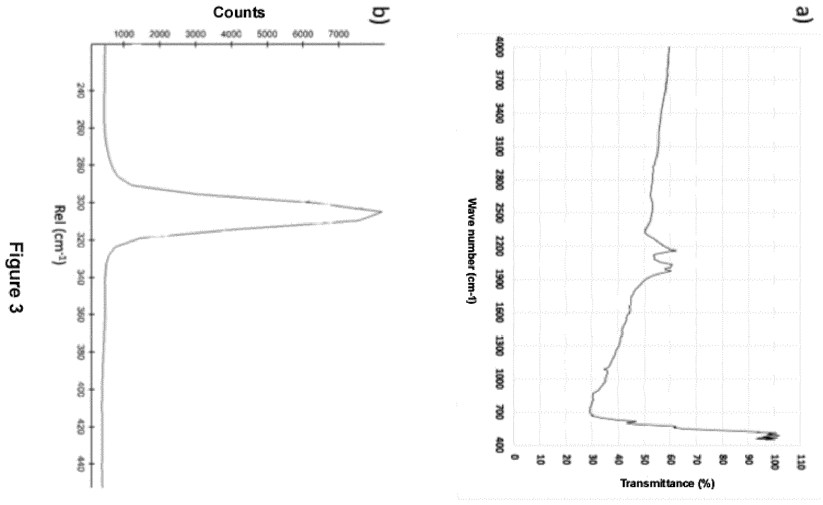

Figures 3a and 3b show the infrared spectrum (Figure 3a) and the Raman spectrum (Figure 3b) of an α-germanium crystal of the invention. The bands of the IR and Raman vibrational spectra coincide with those described for an α-germanium crystal, and therefore confirm the germanium composition and the crystal structure of the crystal of the invention.

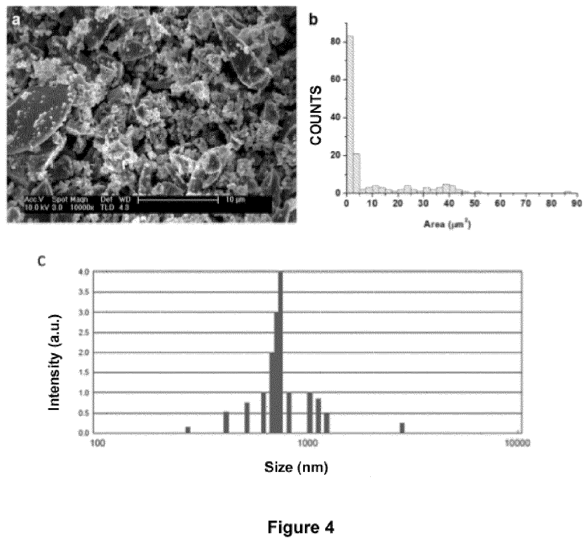

The α-germanium crystal of the present invention exhibits lamellar or planar morphology. In the context of the present invention, "lamellar morphology" is understood to mean that the crystal of the invention has a planar or sheet-like morphology. The term "sheet" refers to a planar morphology in which the lateral dimensions of the sheet are greater than that corresponding to the thickness of said sheet. The expression "lateral dimensions" refers to the lengths corresponding to the length and width of the crystal. The α-germanium crystal of the invention has lateral dimensions comprised between 0.1 µm x 0.1 µm and 10 µm x 10 µm, preferably the lateral dimensions of the α-germanium crystal are comprised between 0.1 µm x 0.1 µm and 8 µm x 8 µm, preferably between 0.1 µm x 0.1 µm and 6 µm x 6 µm. In a preferred embodiment, the α-germanium crystal of the invention has lateral dimensions comprised between 0.1 µm x 0.1 µm and 5 µm x 5 µm, more preferably between 0.2 µm x 0.2 µm and 4 µm x 4 µm, more preferably between 0.4 µm x 0.4 µm and 2 µm x 2 µm, more preferably between 0.6 µm x 0.6 µm and 1 µm x 1 µm, more preferably 0.8 µm x 0.8 µm. Figure 4a shows the SEM image of α-germanium crystals of the invention. This figure allows seeing the lamellar morphology of the crystals. Figure 4b shows the histogram of the area of the crystals observed in Figure 4a. The histogram shows that most of the measured crystals have lateral dimensions less than 5 µm x 5 µm.

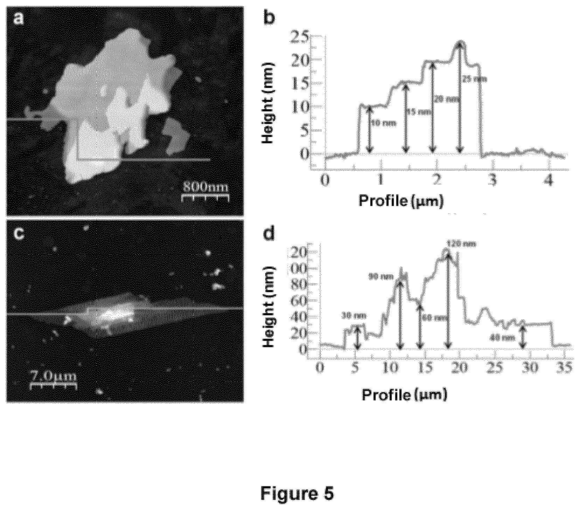

The α-germanium crystal of the invention furthermore exhibits a thickness comprised between 0.56 nm and 100 nm, preferably between 0.65 nm and 90 nm, preferably between 1 and 85 nm, more preferably between 1.5 and 75 nm, more preferably between 1.7 and 60 nm, more preferably between 2 and 50 nm. In a preferred embodiment, the thickness of the crystal is comprised between 2 and 20 nm. For thicknesses greater than 100 nm, the α-germanium crystals loose the properties of the lamellar morphology and acquire the properties of the material by volume. Figures 5a and 5c show the topographical images of two crystals of the invention, obtained with an atomic force microscope (AFM). The AFM measurements allow estimating the thickness of the measured crystal, as well as the topography of the surface of said crystal. Figures 5b and 5d show the height profile of the crystals of Figures 5a and 5c, respectively. The height profile of Figure 5b shows regular 5 nm steps in the α-germanium crystal of the invention, wherein each step is associated with several nanosheets of the α-germanium crystal of the invention stacked on top of one another.

The α-germanium crystal of the invention comprises one or more α-germanium nanosheets stacked on top of one another. Particularly, the term "a-germanium nanosheet" refers to the ordering of germanium atoms exhibiting an fcc-type crystal structure in sheet form, wherein said sheet has lateral dimensions equal to or greater than hundreds of nanometers, and an approximate thickness of 0.56 nm. In a particular embodiment, the α-germanium crystal of the present invention comprises a nanosheet.

In another particular embodiment, the α-germanium crystal of the present invention comprises 2 to 150 α-germanium nanosheets stacked on top of one another, preferably 3 to 100 α-germanium nanosheets stacked on top of one another, preferably 4 to 50 α-germanium nanosheets stacked on top of one another, preferably 5 to 40 α-germanium nanosheets stacked on top of one another, more preferably 6 to 30 α-germanium nanosheets stacked on top of one another, more preferably 10 α-germanium nanosheets stacked on top of one another. The crystal of invention comprising more than one nanosheet has lateral dimensions equal to or greater than hundreds of nanometers and a thickness less than 100 nm. The thickness of the α-germanium crystal of the invention varies depending on the number of nanosheets it comprises, and depending on the specific thickness of each nanosheet.

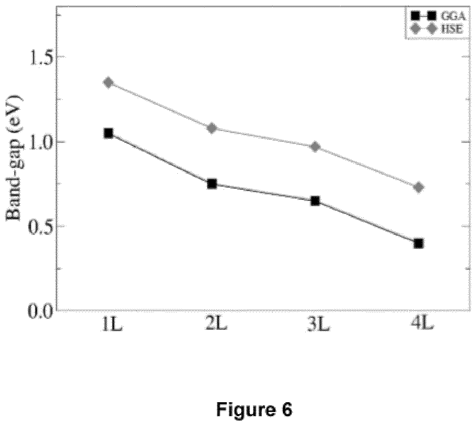

The inventors have surprisingly found that the electronic properties of the α-germanium crystal of the invention vary with the thickness of the crystal. In this sense, the inventors have developed calculations in the context of the density functional theory (DFT) that have allowed predicting some of the electronic properties of the experimentally obtained systems. Said calculations have been carried out with the Quantum Espresso computational package [P. Giannozzi, et al., J. of Phys.: Condensed Matter, 21(39):395502 (19 pp), (2009)] implementing DFT with the help of pseudopotentials and planar waves as a basis. Generalized gradient approximation (GGA-PBE) has generically been used [J. P. Perdew et al., Phys. Rev. Lett., 77, 3865-3868 (1996)] to describe the exchange correlation potential. The electron-ion interaction is described by the Troullier-Martins pseudopotentials [N. Troullier and J. L. Martins, Phys. Rev. B 43, 1993-2006, (1991)]. The cut-off energies were set at 25 Ry and 150 Ry for planar waves and charge density, respectively, and a Monkhorst-Pack scheme [H. Monkhorst and J. D. Pack, Phys. Rev. B, 13, 5188 (1976)] with a 12 x 12 x 1 k-point mesh was used for integration in the Brillouin zone (BZ). Figure 6 shows the volume gap variation depending on the number of nanosheets of the crystal of the invention. The size of the gap is known to be underestimated with the use of the GCA-PBE functional, and therefore the gap obtained with the HSE functional is also shown (screened hybrid functional proposed by Heyd, Scuseria, and Ernzerhof [J. Chem. Phys. 118, 8207 (2003); J. Chem. Phys. 124, 219906(E) (2006)]), which quantitatively improves results in this sense. The figure shows a strong dependence of the gap on the number of nanosheets (1L-4L), progressively approaching the volume gap of germanium (0.67 eV at 300 K) (in the case of the functional HSE). Said dependence can be readily understood as a result of the quantum confinement (110)-directed electron states around the Gamma point. Furthermore, by means of these tests it has been determined that the optimal thickness of the α-germanium crystal of the invention is comprised between 0.56 and 100 nm. Likewise, depending on the final application of the crystal of the invention and the required electronic properties, the particular thickness of the α-germanium crystal will vary in the mentioned range.

The term "gap", "band gap", or "forbidden energy gap" refers to the minimal energy required to excite an electron of a solid from its state linked to a free state which allows it to participate in conduction. Likewise, the term "gap", "band gap", or "forbidden energy gap" refers to the difference in energy between the highest level of the valence band and the lowest level of the conduction band of a solid. Particularly, the conductivity of a solid depends on the width of its gap.

The α-germanium crystal of the present invention may be in powder form. Therefore, in one aspect the invention relates to the powder comprising the α-germanium crystal of the invention. The α-germanium crystals contained in the powder have lateral dimensions comprised between 0.1 µm x 0.1 µm and 10 µm x 10 µm and thicknesses comprised between 0.56 and 100 nm.

The α-germanium crystal of the invention, as well as the α-germanium powder of the invention, can be incorporated in an electronic device for application. Therefore, a particular aspect of the invention relates to the electronic device comprising the α-germanium crystal of the invention or the powder of the invention. In a particular embodiment, the device comprising the α-germanium crystal of the invention or the powder of the invention is an optoelectronic device. Particularly, the energy of the band gap of the method of the invention allows light to be readily absorbed. Examples of optoelectronic devices which may comprise the α-germanium crystal of the invention or the powder of the invention include optical sensors/nanosensors and/or components for photovoltaic cells.

The α-germanium crystal of the invention or the powder comprising the α-germanium crystal of the invention can be dispersed in organic solvents, water, or a mixture of both, to form stable dispersions. Therefore, one aspect of the invention relates to the dispersion comprising the α-germanium crystal of the invention or the powder comprising the α-germanium crystal of the invention dispersed in water, organic solvents, or in a mixture of water and organic solvents. Examples of organic solvents in which the α-germanium crystal of the invention or the powder comprising the α-germanium crystal of the invention can be dispersed include ethanol, 2-propanol, and mixtures thereof in different proportions with water, as well as other pure solvents such as tetrahydrofuran (THF) or N-methyl-2-pyrrolidone (NMP). Preferably, the α-germanium crystal of the invention or the powder comprising the α-germanium crystal is dispersed in organic solvents, water, or a mixture of both applying ultrasounds in short exposure times to prevent crystal deterioration. The maximum value ultrasound power applied to prevent the crystals from oxidizing is 380 W, and the maximum time applying this ultrasound power before the crystal deteriorates is 40 minutes.

Another aspect of the invention relates to an ink comprising the dispersion of the invention.

In the context of the present invention, the term "ink" refers to a liquid which contains several pigments or colorants used to color a surface. The ink of the present invention comprising a dispersion of α-germanium crystals of the invention confers the electronic properties which are characteristic of the α-germanium crystals of the invention on the surface to which the ink is applied. Likewise, the ink of the invention may contain other additives common in inks such as, for example, plasticizers, waxes, surfactants, antifoaming agents, antimicrobial agents, adhesion promoters, antioxidants, and catalysts. Furthermore, the printing method used, as well as the properties required in the printed product, will determine the final composition of the ink of the invention.

The good wettability and drying capacity of the crystal or of the powder of the invention allows their application by means of screen-printing, drop-casting, spraying, or spin-coating. Therefore, another aspect of the invention relates to the method of application of the dispersion of the invention or of the ink of the invention comprising the application of the dispersion or of the ink by means of screen-printing, drop-casting, spraying, or spin-coating.

### Methods of preparing the crystal

### Grinding method

The present invention also relates to a first method of preparing the α-germanium crystal of the invention, which method comprises grinding polycrystalline α-germanium at a rotating speed comprised between 1000 and 3000 rpm, in the presence of at least one alcohol, wherein said alcohol is a linear, branched, or cyclic chain alcohol and has a number of carbons comprised between 3 and 5 atoms; or in the presence of a mixture comprising at least one alcohol and water, wherein said alcohol of the mixture is a linear, branched, or cyclic chain alcohol and has a number of carbons comprised between 3 and 5 atoms, and wherein the content of said alcohol in said mixture is comprised between 60% and 99% by volume.

The first method of preparing the α-germanium crystal of the invention comprises grinding polycrystalline α-germanium. In the context of the present invention, the expression "polycrystalline α-germanium" refers to a plurality of α-germanium crystals, wherein said crystals can exhibit a different crystallographic orientation. The starting polycrystalline α-germanium in the first method of the invention can be, for example, in powder, granule, bead, or chip form. Preferably, the polycrystalline α-germanium which is ground according to the first method of the invention has a purity greater than 99%. Polycrystalline α-germanium suitable for the first method of the invention is available on the market. For example, polycrystalline α-germanium suitable for the first grinding method of the present invention can be acquired from Smart-Elements or Aldrich Co.

In the grinding method of the invention, polycrystalline α-germanium is ground in the presence of at least one alcohol or in the presence of a mixture comprising at least one alcohol and water. The inventors have surprisingly found that the α-germanium crystals with lamellar morphology of the invention are only produced when polycrystalline α-germanium grinding is performed at a rotating speed comprised between 1000 and 3000 rpm and in the presence of at least one alcohol, wherein said alcohol is a linear, branched, or cyclic chain alcohol and has a number of carbons comprised between 3 and 5 atoms, or in the presence of a mixture comprising at least one alcohol and water, wherein said alcohol is a linear, branched, or cyclic chain alcohol and has a number of carbons comprised between 3 and 5 atoms, and wherein the content of said alcohol in said mixture is comprised between 60% and 99% by volume. The inventors have observed that when grinding is performed in the presence of other alcohols other than those defined, polycrystalline α-germanium oxidizes, forming GeO₂. Therefore, in a particular embodiment the method of the invention is performed in the presence of an alcohol, wherein said alcohol is a linear, branched, or cyclic chain alcohol and has a number of carbons comprised between 3 and 5 atoms. In another particular embodiment, the method of the invention is performed in the presence of a mixture comprising at least one alcohol and water, wherein said alcohol is a linear, branched, or cyclic chain alcohol and has a number of carbons comprised between 3 and 5 atoms, and wherein the content of said alcohol in said mixture is comprised between 60% and 99% by volume. In a preferred embodiment, the alcohol used in the first method of the invention is selected from isopropyl alcohol or 2-propanol, n-butanol, n-pentanol, and mixtures thereof. Therefore, the grinding method of the invention can be carried out in the presence of at least one of said alcohols, or in the presence of a mixture comprising at least one of said alcohols and water. In a more preferred embodiment, the alcohol used in the first method of the invention is isopropyl alcohol or 2-propanol.

When grinding takes place in a mixture of water and alcohol, the alcohol content in said mixture is comprised between 60% and 99% by volume, preferably between 65 and 95% by volume, more preferably between 70% and 90% by volume, more preferably between 75% and 85% by volume, even more preferably in a mixture where the alcohol content in said mixture is 80% by volume. Even more preferably, grinding takes place in a mixture of water and alcohol, wherein said alcohol is isopropyl alcohol or 2-propanol and the content of said alcohol in the mixture with water is 80% by volume.

In a particular embodiment, the first method of the invention comprises grinding polycrystalline α-germanium in a ball mill. Alternatively, other grinding methods such as the use of mortars can be used.

In the first method of the invention, the rotating speed during the grinding process is comprised between 1000 and 3000 rpm. In a particular embodiment, grinding is performed at a grinding speed comprised between 1250 and 1750 rpm, more preferably the grinding speed is 1500 rpm. In a preferred embodiment, the grinding speed is 3000 rpm. Likewise the grinding time may range between 10 min and 2h, preferably between 20 min and 1h 40 min, more preferably between 30 min and 1h 20 min, more preferably between 40 min and 1h. In a more preferred embodiment, grinding is performed at 3000 rpm for 1h.

The grinding method of the invention may further comprise a step of drying the obtained α-germanium crystal. Therefore, in a particular embodiment, the method described further comprises a step of vacuum-drying the obtained α-germanium crystal. Preferably, the described method further comprises a step of vacuum-drying at 100°C.

Other grinding methods have been used in the state of the art for preparing germanium crystals. Thus, for example, E. Gaffet [Mat. Sci. and Eng., A136 (1991) 161-169] discloses grinding in pure commercial germanium crystals in argon atmosphere in a ball mill. The powders obtained by this disclosed method have a spherical particle morphology, and their crystal structure is microcrystalline, nanocrystalline, or amorphous. However, none of the known grinding methods allows obtaining α-germanium crystals with lamellar morphology.

The invention also relates to the α-germanium crystal obtainable by the first method of the invention, wherein said method comprises grinding polycrystalline α-germanium at a rotating speed comprised between 1000 and 3000 rpm in the presence of at least one alcohol, wherein said alcohol is a linear, branched, or cyclic chain alcohol and has a number of carbons comprised between 3 and 5 atoms; or in the presence of a mixture comprising at least one alcohol and water, wherein said alcohol of the mixture is a linear, branched, or cyclic chain alcohol and has a number of carbons comprised between 3 and 5 atoms, and wherein the content of said alcohol in said mixture is comprised between 60% and 99% by volume.

Likewise, the invention also relates to the powder comprising the α-germanium crystal obtainable by the first method of the invention described above, wherein said method comprises grinding polycrystalline α-germanium at a rotating speed comprised between 1000 and 3000 rpm in the presence of at least one alcohol, wherein said alcohol is a linear, branched, or cyclic chain alcohol and has a number of carbons comprised between 3 and 5 atoms; or in the presence of a mixture comprising at least one alcohol and water, wherein said alcohol of the mixture is a linear, branched, or cyclic chain alcohol and has a number of carbons comprised between 3 and 5 atoms, and wherein the content of said alcohol in said mixture is comprised between 60% and 99% by volume.

Furthermore, the inventors have observed that the band gap of the α-germanium crystals obtained by the grinding method of the invention varies depending on the thickness of each crystal. In this sense, the α-germanium crystals obtained by the grinding method of the invention can be separated according to their thickness by centrifugation techniques. To that end, the α-germanium crystals obtained by the grinding method of the invention are dispersed in organic solvents, water, or a mixture of both, to form stable dispersions. The dispersions of the α-germanium crystals are subsequently subjected to centrifugation to separate the α-germanium crystals according to their thickness.

Therefore, in a particular embodiment the grinding method of the invention further comprises the dispersion of the obtained α-germanium crystal in water, organic solvents, or in a mixture of water and organic solvents, and the centrifugation of said dispersion. Examples of organic solvents in which the α-germanium crystal of the invention or the powder comprising the α-germanium crystal of the invention can be dispersed include ethanol, 2-propanol, and mixtures thereof in different proportions with water, as well as other pure solvents such as tetrahydrofuran (THF) or N-methyl-2-pyrrolidone (NMP).

### Sonication method

The present invention also provides another method of preparing the α-germanium crystal which is an alternative to the grinding method described above. Therefore, another aspect of the invention relates to a second method of preparing the α-germanium crystal of the invention, which method comprises:
a) preparing a dispersion of polycrystalline α-germanium in:
   - at least one alcohol, wherein said alcohol is a linear, branched, or cyclic chain alcohol and has a number of carbons comprised between 3 and 5 atoms; or
   - in a mixture comprising at least one alcohol and water, wherein said alcohol of the mixture is a linear, branched, or cyclic chain alcohol and has a number of carbons comprised between 3 and 5 atoms, and wherein the content of said alcohol in said mixture is comprised between 60% and 99% by volume,
b) sonicating and centrifuging the dispersion obtained in a), wherein the centrifugation speed is comprised between 500 rpm and 3000 rpm, and
c) separating the supernatant to obtain the α-germanium crystal of the invention.

In step a) of the described second method, a dispersion of polycrystalline α-germanium is prepared. Preferably, the starting polycrystalline α-germanium has a purity greater than 99%. The polycrystalline α-germanium of step a) of the second method of the invention may be, for example, in powder, granule, bead or, chip form. Polycrystalline α-germanium suitable for the sonication method of the present invention can be acquired from Smart-Elements or Aldrich Co.

The starting polycrystalline α-germanium is dispersed in at least one alcohol, wherein said alcohol is a linear, branched, or cyclic chain alcohol and has a number of carbons comprised between 3 and 5 atoms; or in a mixture comprising at least one alcohol and water, wherein said alcohol of the mixture is a linear, branched, or cyclic chain alcohol and has a number of carbons comprised between 3 and 5 atoms, and wherein the content of said alcohol in said mixture is comprised between 60% and 99% by volume. Methods of dispersing crystals in water are well known in the state of the art.

In a preferred embodiment, in step a) polycrystalline α-germanium is dispersed in at least one alcohol, or in a mixture comprising at least one alcohol and water, wherein said alcohol is selected from isopropyl alcohol, 2-propanol, n-butanol, n-pentanol, and mixtures thereof. Therefore, in step a) polycrystalline α-germanium can be dispersed in at least one of said alcohols, or in a mixture comprising at least one of said alcohols and water. In a preferred embodiment, polycrystalline α-germanium is dispersed in step a) of the sonication process in isopropyl alcohol or 2-propanol, or in a mixture of any of said alcohols in water.

When the dispersion is prepared in a mixture of water and alcohol, the alcohol content in said mixture is comprised between 60% and 99% by volume, preferably between 65 and 95% by volume, more preferably between 70% and 90% by volume, more preferably between 75% and 85% by volume, even more preferably in a mixture where the alcohol content in said mixture is 80% by volume. Even more preferably, the dispersion is prepared in a mixture of water and alcohol, wherein said alcohol is isopropyl alcohol or 2-propanol and the content of said alcohol in the mixture with water is 80% by volume.

In step b) of the described second method, the dispersion of step a) is sonicated and centrifuged. Sonication of the dispersion is performed by applying ultrasounds to the dispersion prepared in the step a). In a particular embodiment, the dispersion is sonicated at a power of 400 W or less. In a preferred embodiment, the dispersion is sonicated with an ultrasonic tip at 400 W and 24 kHz for 45 min. The inventors have observed that at ultrasound powers greater than 400 W, the α-germanium crystals begin to experience morphological changes. Furthermore, for a maximum ultrasound power of 400 W, maximum sonication time is about 45 min; for longer times, the α-germanium crystals deteriorate.

In step b) of the sonication method of the invention, the sonicated dispersion is also subjected to centrifugation, wherein the centrifugation speed of the sonicated dispersion is comprised between 500 and 3000 rpm, preferably between 750 and 2500 rpm, more preferably between 1000 and 2000 rpm, more preferably between 1200 and 1500 rpm. Likewise, the centrifugation time may range between 1 min and 10 min, preferably between 2 min and 5 min. In a preferred embodiment, the sonicated dispersion is centrifuged at 1000 rpm for 3 min.

The inventors have found that the sonication and centrifugation conditions used in the described sonication method determine the lateral dimensions and the thickness of the obtained α-germanium crystals. Likewise, the inventors have found that the thickness of the α-germanium crystals obtained by the methods of the invention determines the band gap of said crystals, and therefore their electronic properties. Therefore, the sonication method of the invention allows obtaining α-germanium crystals with the required electronic properties by varying the sonication and centrifugation conditions of the method of the invention. Generally, at lower sonication times, the dimensions of α-germanium crystals increase, for example, using 10 minutes of sonication, maintaining the power of 400 W, frequency of 37 KHz, and leaving the centrifugation conditions unchanged, only nanosheets with thicknesses greater than 10 nm are produced.

In step c) of the second method of the invention, the supernatant is separated to obtain the α-germanium crystal with lamellar morphology of the invention. In a preferred embodiment, the supernatant is separated from the dispersion by centrifugation, filtration, or decantation.

In a preferred embodiment, the described second method further comprises a step of drying the obtained α-germanium crystal. In a particular embodiment, the described second method further comprises a step of vacuum-drying the obtained α-germanium crystal. Preferably, the described method comprises a step of vacuum-drying at 100°C.

The invention also relates to the α-germanium crystal which can be obtained by the sonication method of the invention, wherein said method comprises:
a) preparing a dispersion of polycrystalline germanium in:
   - at least one alcohol, wherein said alcohol is a linear, branched, or cyclic chain alcohol and has a number of carbons comprised between 3 and 5 atoms; or
   - in a mixture comprising at least one alcohol and water, wherein said alcohol of the mixture is a linear, branched, or cyclic chain alcohol and has a number of carbons comprised between 3 and 5 atoms, and wherein the content of said alcohol in said mixture is comprised between 60% and 99% by volume,
b) sonicating and centrifuging the dispersion obtained in a), wherein the centrifugation speed is comprised between 500 rpm and 3000 rpm, and
c) separating the supernatant to obtain the α-germanium crystal of the invention.

Likewise, the invention also relates to the powder comprising the α-germanium crystal obtainable by the sonication method of the invention described above.

### EXAMPLES:

Two methods performed for obtaining the lamellar α-germanium crystal of the invention are described.

### 1. Wet-grinding:

200 mg of commercial polycrystalline α-germanium crystals (SmartElements or Aldrich with a purity of 99.999%) were placed in a steel pebble bed reactor, leaving two thirds of the reactor volume free. 1 ml of a mixture of water with isopropyl alcohol (2-propanol/H₂O at a ratio by volume of 4:1) was added and ground in the reactor at 3000 rpm for 60 min. The α-germanium powder obtained after grinding was vacuum-dried at 60°C for 12 h and stored in Ar atmosphere to prevent possible oxidation.

### 2. Ultrasounds:

A dispersion with a starting concentration equal to 20 g/L of commercial polycrystalline α-germanium crystals (Smart-Elements or Aldrich with a purity of 99.999%) in a mixture of water with isopropyl alcohol (2-propanol/H₂O at a ratio by volume of 4:1) was prepared. The dispersion was sonicated with an ultrasonic tip at 400 W and 24 kHz for 45 min. The resulting dispersion was centrifuged at 1000 rpm for 3 min and the supernatant was recovered.

In both cases, the same target material was obtained, which was characterized by different techniques as described below.

Therefore, Figure 1 shows the powder diffractogram measured in the α-germanium crystal obtained following the wet-grinding method. The diffractogram confirms that the germanium crystal has structure of type α, wherein the atoms of germanium are ordered forming a diamond-type structure. The equipment used to obtain the diffractogram of Figure 1 was an X'Pert PRO Panalytical diffractometer with 2θ/θ geometry. The measurement conditions used were: 2θ initial = 2°, 2θ final = 90°, pitch 2θ = 0.04, and sec/pitch = 2.

Figure 2 shows the TEM image of a nanosheet of the obtained α-germanium crystal according to the ultrasound method. The equipment used to obtain the images of Figure 2 was a JEOL JEM 2100 FX TEM, with an acceleration voltage of 200 kV. Particularly, Figure 2b shows a detail of the crystal nanosheet in which the ordering of the germanium atoms can be seen. The electron diffraction pattern of the crystal (inserted image in Figure 2b) confirms the α-type cubic structure of the α-germanium crystal.

Figures 3a and 3b show the infrared spectrum (Figure 3a) and Raman spectrum (Figure 3b) of the α-germanium crystal obtained according to the wet-grinding method. The bands of the IR and Raman vibrational spectral coincide with those described for α-germanium crystal; therefore they confirm the composition of germanium and the crystal structure of the crystal. The infrared spectrum of Figure 3a was obtained with a PerkinElmer 100 spectrometer in attenuated total reflection (ATR) mode, using an ATR PIKE Technologies MIRacle Single Reflection Horizontal Accessory. The Raman spectra were recorded in WITec/ALPHA 300AR equipment on SiO₂ surfaces.

Figure 4a shows the SEM image of α-germanium crystals obtained also following the wet-grinding method. The SEM image used to obtain the images of Figure 4a was a Philips XL 30 S-FEG Field Emission Scanning Electron Microscope. The figure allows seeing the lamellar morphology of the crystals. Figure 4b shows the histogram of the area of the crystals observed in Figure 4a. The histogram shows that most of the measured crystals have lateral dimensions less than 5 µm x 5 µm.

Figures 5a and 5c show the topographical images of two crystals, one obtained according to the wet-grinding method and the other obtained by means of ultrasounds, said images being obtained with an atomic force microscope (AFM). The AFM measurements allow estimating the thickness of the measured crystal, as well as the topography of the surface of said crystal. Figures 5b and 5d show the height profile of the crystals of Figures 5a and 5c, respectively. The height profile of Figure 5b shows regular 5 nm steps in the α-germanium crystal, wherein each step is associated with several α-germanium crystal nanosheets stacked on top of one another.

The AFM measurements shown were performed in AFM equipment at SEGAINVEX of the Universidad Autónoma of Madrid with an electronic Cervantes Fullmode from Nanotec Electronica S.L. All the images were obtained in contact mode to avoid possible artifacts in the nanosheet height measurement. Olympus OMCL-RC800PSA cantilevers with an oscillation constant of 0.39 N/m and an end of tip radius of 15-20 nm were used.

It should be pointed out that synthesis conditions were determining factors when obtaining the desired material and not other forms of germanium that are already known (oxide, etc.). Obtaining laminar α-germanium nanostructures by different methods verifies the synthesis capacity of this material.

**Table 1 includes a series of additional experiments carried out with other solvents or mixture of solvents with water:**

| SOLVENT | Product |
|---|---|
| 2-Propanol (100%) | α-Ge nanosheets |
| 2-Propanol/H₂O (80%) | α-Ge nanosheets |
| 2-Propanol/H₂O (60%) | Mixture of α-Ge crystals + α-Ge nanosheets |
| n-Butanol | Mixture of α-Ge nanosheets + GeO₂ |
| n-Pentanol | Mixture of α-Ge nanosheets + GeO₂ |
| H₂O | GeO₂ |
| EtOH | GeO₂ |
| Toluene | GeO₂ |
| Air ball mill | GeO₂ |

## Claims

1. An α-germanium crystal with lamellar morphology, wherein said crystal comprises one or more α-germanium nanosheets stacked on top of one another, and wherein said crystal exhibits a thickness comprised between 0.56 nm and 100 nm and lateral dimensions comprised between 0.1 µm x 0.1 µm and 10 µm x 10 µm.

2. The α-germanium crystal according to claim 1, exhibiting lateral dimensions comprised between 0.1 µm x 0.1 µm and 5 µm x 5 µm.

3. The α-germanium crystal according to any of claims 1 or 2, wherein said crystal comprises 2 to 150 nanosheets of α-germanium stacked on top of one another.

4. The α-germanium crystal according to any of claims 1 to 3, wherein the thickness of the crystal is comprised between 2 and 20 nm.

5. Method of preparing the α-germanium crystal as defined in any of claims 1 to 4, wherein said method comprises grinding polycrystalline α-germanium at a rotating speed comprised between 1000 and 3000 rpm, in the presence of:
- at least one alcohol, wherein said alcohol is a linear, branched, or cyclic chain alcohol and has a number of carbons comprised between 3 and 5 atoms; or
- a mixture comprising at least one alcohol and water, wherein said alcohol of the mixture is a linear, branched, or cyclic chain alcohol and has a number of carbons comprised between 3 and 5 atoms, and wherein the content of said alcohol in said mixture is comprised between 60% and 99% by volume.

6. Method according to claim 5, which further comprises dispersing the obtained α-germanium crystal in water, organic solvents, or in a mixture of water and organic solvents, and centrifuging said dispersion.

7. Method of preparing the α-germanium crystal as defined in any of claims 1 to 4, which method comprises:
a) preparing a dispersion of polycrystalline α-germanium in:
- at least one alcohol, wherein said alcohol is a linear, branched, or cyclic chain alcohol and has a number of carbons comprised between 3 and 5 atoms; or
- a mixture comprising at least one alcohol and water, wherein said alcohol of the mixture is a linear, branched, or cyclic chain alcohol and has a number of carbons comprised between 3 and 5 atoms, and wherein the content of said alcohol in said mixture is comprised between 60% and 99% by volume,
b) sonicating and centrifuging the dispersion obtained in a), wherein the centrifugation speed is comprised between 500 rpm and 3000 rpm, and
c) separating the supernatant to obtain the α-germanium crystal as defined in claims 1 to 4.

8. Method according to any of claims 5 to 7, which method further comprises a step of vacuum-drying the obtained α-germanium crystal.

9. Method according to any of claims 5 to 8, wherein the alcohol is selected from isopropyl, 2-propanol, n-butanol, n-pentanol alcohol and mixtures thereof.

10. Method according to any of claims 5 to 9, wherein the alcohol content in the mixture of alcohol and water is 80% by volume.

11. Powder comprising the α-germanium crystal as defined in any of claims 1 to 4.

12. Electronic device comprising the α-germanium crystal as defined in any of claims 1 to 4 or the powder according to claim 11.

13. Dispersion comprising the α-germanium crystal as defined in any of claims 1 to 4 or the powder as defined in claim 11 dispersed in water, organic solvents, or in a mixture of water and organic solvents.

14. Ink comprising the dispersion as defined in claim 13.

15. Method of application of the dispersion as defined in claim 13 or of the ink as defined in claim 14, comprising the application of the dispersion or of the ink by means of screen-printing, drop-casting, spraying, or spin-coating.
